# EUROPEAN PATENT APPLICATION

(11) **EP 1 453 079 A2**
(43) Date of publication of application: **01.09.2004**
(21) Application number: 04004234.3
(22) Date of filing: 25.02.2004
(51) Int. Cl.: H01L 21/00, C23C 16/44

(54) **Outer tube made of silicon carbide and thermal treatment system for semiconductors**

(30) Priority: 27.02.2003 JP 2003051329
(71) Applicant: Asahi Glass Company, Limited, Chiyoda-ku, Tokyo 100-8405 (JP)
(72) Inventor: Takata, Masaaki, Takasago-shi Hyogo (JP); Kageyama, Nobuo, Takasago-shi Hyogo (JP); Otaguro, Susumu, Kanagawa-ku Yokohama-shi Kanagawa (JP)
(74) Representative: Müller-Boré & Partner Patentanwälte

(57) **Abstract**

In an outer tube, which is made of silicon carbide, and which has an upper portion closed and a lower portion opened, has the lower portion formed with a tapered portion so as to expand a diameter thereof toward a lower end thereof, and has a flange formed on an outer peripheral side of the lower portion; the following conditions are met:
1) a ratio of tₐ/D₁ is from 0.0067 to 0.025,
2) a product of tₐ×D₁ is from 600 to 4,000 (mm²),
3) (D_{F2}-D_{F1})×t_{c}/(D₁×tₐ) is from 0.1 to 0.7, and
4) L₁/L₂ is from 1 to 10;
where the outer tube has a thickness of tₐ (mm) and an inner diameter of D₁ (mm), the flange has a thickness of t_{c} (mm), an inner diameter of D_{F1} (mm) and an outer diameter of D_{F2} (mm), and the tapered portion has a height L₁ (mm) and an expanse of L₂ (mm).

## Description

The present invention relates to an outer tube made of silicon carbide, which is used in a thermal treatment system for semiconductors, such as a low pressure CVD system for depositing, e.g., a polysilicon film, a nitride film or another non-oxide film on a surface of a semiconductor wafer, and a high temperature thermal treatment system for depositing an oxide film on a surface of a semiconductor wafer.

For the outer tube used in low pressure CVD systems for thermal treatment of semiconductors and reactors for high-temperature thermal treatment, quartz glass has been used, for example, for reasons that it is easy to obtain high-purity glass, it has a thermal resistance, it has a low thermal expansion coefficient and a small thermal stress generated, and it is excellent at thermal insulation due to a low thermal conductivity. When a deposited film is a polysilicon film or a nitride film, the use of an outer tube made of silicon carbide has been recently proposed from the viewpoints that the difference in thermal expansion coefficient between the deposited film and quartz glass causes the deposited film to peel off in a system and contaminate a wafer and that the thermal resistance is further improved (see Patent Documents 1 and 2).

However, the use of silicon carbide has a problem that fracture is easily caused due to tensile stresses or bending stresses mainly generated at three locations A, B and C shown in Fig. 7 of Patent Document 2 (corresponding to Fig. 4 of the application) since silicon carbide has a higher thermal expansion coefficient and a higher thermal conductivity than quartz glass. The use of silicon carbide also has a problem that an O-ring interposed between the outer tube and a base is apt to be seized because of silicon carbide having a high thermal conductivity, and the gas-sealing ability is therefore impaired easily.

As one of the measures, it has been proposed a method (hereinbelow, referred to as measure A) wherein the distance between the bottom surface of an outer tube made of silicon carbide and the lowest end of a heater is set at a length of 200 mm or longer in order to locate an O-ring physically away from a heat source (see Patent Document 1). As another measure, it has been proposed a method (hereinbelow, referred to as measure B) wherein a seal ring is interposed between a flange of an outer tube made of silicon carbide and a base and wherein an inner peripheral portion of the flange that is radially more inward than the seal ring is contacted to and supported by the base (see Patent Document 2).

However, it has been recently difficult to ensure a length of 200 mm or longer. This is because it is strongly demanded to deal with a large volume of silicon wafers at one time and because there is a tendency to spread an isothermal heating zone or to bring the lower end of a heater near to a base in order to increase the number of silicon wafers to be dealt with in a thermal treatment system for semiconductors, such as a low pressure CVD system. From this viewpoint, measures other than measure A have been demanded more and more.

Additionally, the diameter of silicon wafers has been further increased from 200 mm to 300 mm or longer, and the inner diameter of outer tubes has been accordingly increased to 350 mm or longer. For this reason, in the case of adopting measure B, there is a possibility that the flange of an outer tube is insufficiently cooled and that an insufficient sealing pressure cannot prevent a gas from leaking since an inner peripheral portion of the flange supported by a base has line contact and since the contact location changes according to a thermal treatment temperature.

In other words, no measures other than measure A or measure B, which can produce an outer tube made of silicon carbide satisfying the requirements, such as an increase in diameter, an increase in throughput, and prevention of contamination caused by particles, have not been proposed.
Patent Document 1
   JP-A-9-251991 (page 1 to page 7 and Fig. 1)
Patent Document 2
   JP-A-10-195657 (page 1 to page 8 and Figs. 1 to 7, in particular Fig. 7)

Patent Documents 1 and 2 correspond to USP 5,902,406 and EP-A-0795897.

It is an object of the present invention to provide an outer tube made of silicon carbide, which is capable of having durability in spite of an increase in diameter, spreading an isothermal heating zone to increase the throughput at one time and minimizing contamination caused by particles.

The present invention provides an outer tube, which is made of silicon carbide, and which has an upper portion closed and a lower portion opened, has the lower portion formed with a tapered portion so as to expand a diameter thereof toward a lower end thereof, and has a flange formed on an outer peripheral side of the lower portion; the following conditions being met:
1) a ratio of tₐ/D₁ is from 0.0067 to 0.025,
2) a product of tₐ×D₁ is from 600 to 4,000 (mm²) ,
3) (D_{F2}-D_{F1})×t_{c}/(D₁×tₐ) is from 0.1 to 0.7, and
4) L₁/L₂ is from 1 to 10;
where the outer tube has a thickness of tₐ (mm) and an inner diameter of D₁ (mm), the flange has a thickness of t_{c} (mm), an inner diameter of D_{F1} (mm) and an outer diameter of D_{F2} (mm), and the tapered portion has a height L₁ (mm) and an expanse of L₂ (mm).

In the drawings:
Fig. 1 is a vertical cross-sectional view of the outer tube according to an embodiment of the present invention;
Fig. 2 is an enlarged vertical cross-sectional view of a flange of the outer tube when being put on a base;
Fig. 3 is a vertical cross-sectional view of a low pressure CVD system with the outer tube used therein; and
Fig. 4 is a schematic view showing stresses generated in a conventional outer tube.

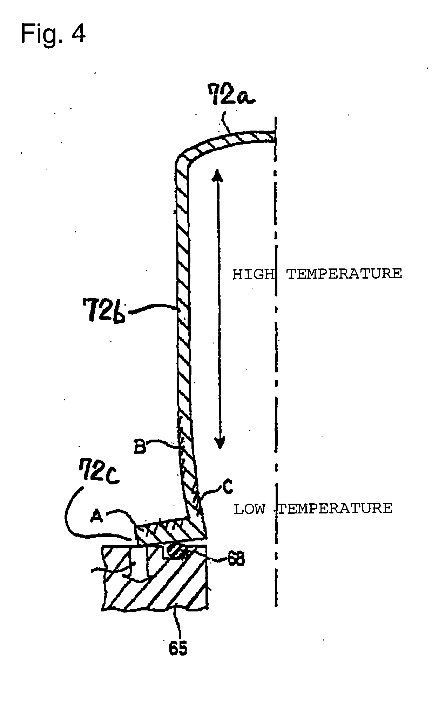

The inventors performed a stress analysis on a case wherein conventional outer tubes (hereinbelow, referred to as "known outer tubes" or "known outer tube") were used in a low pressure CVD system. Results of the stress analysis are shown in Fig. 4. When the known outer tubes were used in the low pressure CVD system, main stresses were generated at the locations A, B and C in Fig. 4.

The inventors further performed the stress analysis and found that there was a sort of trade-off relationship that when a measure was taken in order to decrease the stresses generated at the locations A, B and C, the stress generated at another location was increased, or excessive heat flowed in an O-ring interposed between a known outer tube and the base for supporting it. For example, it is supposed that the thickness tₐof a known outer tube is reduced in order to decrease the stress generated at the location A. However, it is impossible to increase the diameter of the known outer tube due to lack of mechanical strength in this case. Conversely, when the thickness tₐ of an outer tube is increased in terms of mechanical strength, the O-ring is seized since excess heat flows in a lower end of the outer tube, due to the high thermal conductivity of silicon carbide, to such a degree that the heat generated exceeds the cooling capacity.

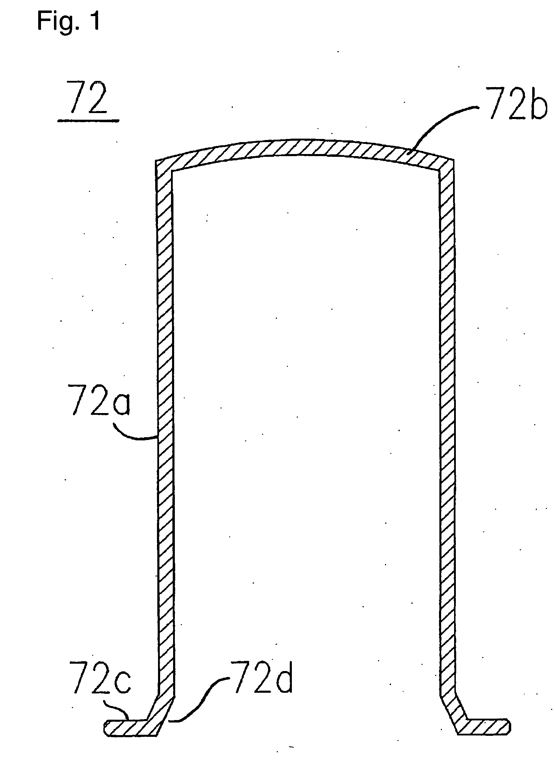

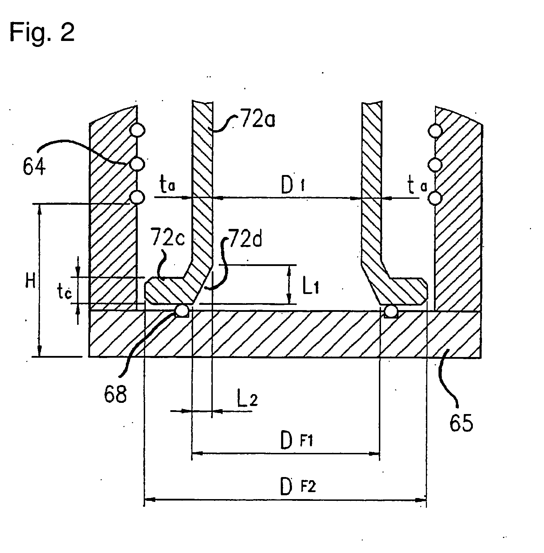

From this viewpoint, the outer tube according to the present invention (hereinbelow, referred to as "novel outer tube") is configured so that the novel outer tube has a thickness limited according to the diameter thereof in order to keep the amount of heat transfer from a hot portion to a cooled lower end of the outer tube in a certain range. Now, the novel outer tube according to an embodiment of the present invention will be explained, referring to the accompanying drawings. Fig. 1 is a vertical cross-sectional view of the novel outer tube according to the embodiment, and Fig. 2 is an enlarged vertical cross-sectional view of a flange of the novel outer tube.

The novel outer tube 72 has an upper portion closed and a lower portion opened. The outer tube has a lower end formed with a tapered portion 72d, and the lower end has an outer peripheral side formed with a flange 72c. When the outer tube has a thickness of tₐ (mm) and an inner diameter of D₁ (mm), when the flange 72c has a thickness of t_{c} (mm) , an inner diameter of D_{F1} (mm) and an outer diameter of D_{F2} (mm), and when the tapered portion 72d has a height L₁ (mm) and an expanse of L₂ (mm) , a ratio of tₐ/D₁ is from 0.0067 to 0.025, and a product of tₐ×D₁ is from 600 to 4,000 (mm²) . The product tₐ×D₁ is relevant to the amount of thermal transfer since tₐ×D₁ is proportional to the cross-sectional area that is obtained by slicing the outer tube.

When the ratio of tₐ/D₁ is lower than 0.0067, there is a possibility that a problem is caused in terms of mechanical strength. When the ratio of tₐ/D₁ is higher than 0.025, there is a possibility that the amount of thermal transfer becomes excessive and the flange is subjected to a great stress (a stress generated at the location A in Fig. 4). It is preferable that the ratio of tₐ/D₁ is from 0.01 to 0.02.

Likewise, when the product of tₐ×D₁ is lower than 600 (mm²), there is a possibility that a problem is caused in terms of mechanical strength. When the product of tₐ×D₁ is higher than 4,000 (mm²), there is a possibility that the amount of thermal transfer becomes excessive. The product of tₐ×D₁ is preferably not higher than 2,000 (mm²), more preferably not higher than 1,400 (mm²).

The novel outer tube 72 has the flange 72c. The flange 72c serves to restrain main portions 72a, 72b and 72d of the outer tubes except for the flange from expanding since the flange is at a temperature near to room temperature even in use while the portions of the outer tubes except for the flange are subjected to a high temperature in use. As a result, bending stresses are generated at the locations B and C in Fig. 4. The bending stresses are not allowed to be excessively great since the bending stresses are greater in proportion to the ratio of t_{c}/tₐ (mm) as the ratio of the thickness t_{c} of the flange to the thickness tₐ of the outer tube.

Since the flange 72c is normally cooled from the outer peripheral side thereof, thermal stresses are generated because of a temperature difference between the inner and outer peripheral sides thereof. It is supposed that the thermal stresses become greater as a ratio of (D_{F2}-D_{F1})/D₁ becomes greater wherein the inner diameter of the flange 72c is D_{F1}, the outer diameter of the flange is D_{F2}, the difference between the inner and outer diameters of the flange is (D_{F2}-D_{F1}), and the inner diameter of the outer flange is D₁. Considering the comparison between simulation and actual products, there is a possibility that when (t_{c}•(D_{F2}-D_{F1}))/(tₐ•D₁) as the product of t_{c}/tₐ and (D_{F2}-D_{F1})/D₁ exceeds 0.7, the novel outer tube is broken by the thermal stresses. The value of the product is preferably not higher than 0.6, more preferably not higher than 0.5. On the other hand, when the value of the product is lower than 0.1, there is a possibility that mechanical strength is insufficient when the inner diameter is increased. The value of the product is preferably not lower than 0.2, more preferably not lower than 0.25.

By making the flange 72c smaller, it is possible to decrease the thermal stresses, i.e., to decrease t_{c} or (D_{F2}-D_{F1}). However, in this case, there is a possibility that the O-ring is seized due to lack of the thermal transfer area for cooling and that a problem is caused in terms of sealing ability due to insufficient width of the sealed portion. From these viewpoints, it is preferable that not only the relationships stated earlier are satisfied but also t_{c}•(D_{F2}-D_{F1}) is from 150 to 1,200 (mm²) . The product t_{c}•(D_{F2}-D_{F1}) is more preferably not lower than 200 (mm²), in particular preferably not lower than 250 (mm²) . On the other hand, the product t_{c}•(D_{F2}-D_{F1}) is more preferably not higher than 1,000 (mm²), in particular preferably not higher than 800 (mm²).

The novel outer tube 72 is effective in an decrease in thermal stresses since the tapered portion 72d is provided at the lower end of the outer tube so as to expand the inner diameter of the outer tube so that the effective length required for thermal conduction can extend to reduce the temperature gradient. The gradient of the tapered portion 72d is represented as a ratio of L₁/L₂ wherein the height of the tapered portion is L₁ (mm) and the expansion that the flange 72c and the tapered portion 72d intersect is L₂ (mm) . The gradient of the tapered portion 72d of the novel outer tube 72 may be from 1 to 10. The gradient of the tapered portion 72d of the novel outer tube 72 is preferably from 2 to 8, more preferably from 3 to 5.

When the tapered portion 72d of the novel outer tube 72 has upper and lower edges of an inner peripheral side rounded with a radius of 2 mm (R2) or above, stress concentration can be avoided. This arrangement is preferable in particular when the novel outer tube is used for high temperature application. It is more preferable that both edges of the tapered portion 72d are rounded with a radius of 4 mm (R4) or above. In order to prevent strength from being reduced by a scratch caused during manufacturing, it is preferable that an inner surface of the tapered portion 72d has a surface roughness Ra of not greater than 7 µm. It is more preferable that the inner surface of the tapered portion 72d has a surface roughness Ra of not greater than 3 µm. It is further preferable that both edges of the tapered portion 72d are rounded with a radius of 2 mm (R2) or above, and that the inner surface of the tapered portion 72d has a surface roughness Ra of not greater than 7 µm.

As long as the novel outer tube 72 is made of silicon carbide for the purpose of treatment of semiconductors, there is no limitation to the material of the novel outer tube. It is preferable that the material has such a high purity that the concentration of impurities typically represented by Fe is not higher than 50 mass ppm. In order to increase the durability against repeated washing by acid, such as HF, it is more preferable that the novel outer tube has a surface coated with a film of silicon carbide by CVD.

There is no limitation to how the novel outer tube 72 is fabricated. The novel outer tube may be fabricated by, e.g., a method wherein an integrally molded article is baked. The novel outer tube may be fabricated by independently molding and baking the peripheral wall 72a, the upper wall 72b and the flange 72c thereof, followed by bonding these parts with, e.g., an adhesive made of silicon carbide.

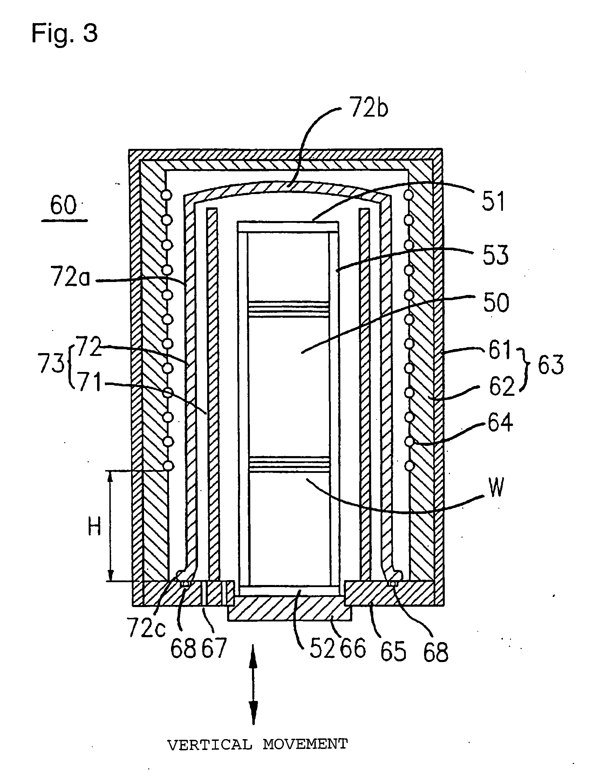

The novel outer tube 72 is preferably used as the outer tube of a thermal treatment system for semiconductors, such as a low pressure CVD system, and a high temperature thermal treatment system, since the novel outer tube is superior in durability and productivity. Fig. 3 shows a case wherein the novel outer tube 72 is used in a low pressure CVD system. The low pressure CVD system 60 includes a reactor wall 63 comprising a metal casing 61 and a thermal insulation material 62. The reactor wall 63 has an inner peripheral side provided with a heater 64. The reactor wall 63 has a lower side closed by a base 65. The base 65 has a central portion formed with an opening for introduction and withdrawal of semiconductor wafers W, and the opening is provided with a lid 66, which can selectively open and close the opening by being vertically moved by an unshown lift. The lid 66 has a wafer boat 50 for loading the wafers W put thereon. The wafer boat 50 comprises end plates 51, 52 and supports 53 connecting therebetween. The base 65 has a gas introduction and discharge port 67.

The base 65 has a dual tube 73 put thereon, the dual tube comprising an inner tube 71 and the novel outer tube 72 surrounding the outer periphery side of the inner tube 71 with a gap. The novel outer tube 72 comprises a peripheral wall 72a in a cylindrical shape, an upper wall 72b closing an upper side of the peripheral wall 72a, and a flange 72c provided on the outer peripheral side of the lower edge of the peripheral wall 72a. The base 65 has an annular recess formed at a portion in contact with a bottom surface of the flange 72c. The recess has an O-ring 68 or a gasket made of, e.g., heat-resistant rubber housed therein to hermetically seal the bottom surface of the flange 72c.

The base 65 has an unshown water jacket formed therein to prevent the O-ring 68 from being heat-damaged. With respect to the application of the novel outer tube 72 to a thermal treatment system for semiconductors, when the thermal treatment system is a low pressure CVD system and the like, the inner tube 71 is needed. When the thermal treatment system is something like a high temperature thermal treatment system, the inner tube is not needed in some cases.

In order to reduce a stress generated at the location B in a thermal treatment system for semiconductors using the novel outer tube 72, it is preferable that the height L₁ (mm) of the tapered portion 72d is substantially half of a distance H (mm) between the lowest end of the heater 64 and the bottom surface of the outer tube. For example, the relationship of H/4<L₁<3•H/4 is preferably. The relationship of H/3<L₁<2• H/3 is more preferable.

### EXAMPLE

Examples of the present invention (Example 1 and Example 2) and comparative examples (Example 3 and Example 4) will be shown.

### EXAMPLE 1

An outer tube 72 made of silicon carbide was fabricated so as to fulfill the conditions of the inner diameter: D₁=307 (mm) , the thickness: tₐ=2.5 (mm) , the height: 1,200 (mm), the thickness of the flange: t_{c}=8 (mm) , the outer diameter of the flange: D_{F2}=360 (mm) , the inner diameter of the flange: D_{F1}=323 (mm), the height of the tapered portion: L₁=34 (mm) and the expansion of the tapered portion: L₂=8 (mm), that is to say, 1) tₐ/D₁=0.0081, 2) tₐ×D₁=768 (mm²) , 3) (D_{F2}-D_{F1})×t_{c}/(D₁×tₐ)=0.39, and 4) L₁/L₂=4.3. In this case, the equation of t_{c}×(D_{F2}-D_{F1})=296 (mm²) was established. Additionally, an inner tube 71, which was made of the same material as the outer tube, was fabricated so as to have an inner diameter of 260 mm and an outer diameter of 268 (mm). The inner and outer tubes were combined together as a dual tube 73.

A deposition process wherein the dual tube 73 was used to deposit a doped silicon (D-Poly) CVD film on each of semiconductor wafers W at 550°C was repeated 40 times. In spite of that the height H of the heater was lowered to 80 mm, which was lower than half of the height of 200 mm in Patent Document 1, a defect, such as a crack, was not observed in particular in the outer tube 72.

### EXAMPLE 2

An outer tube 72 was prepared so as to be fabricated in the same conditions as Example 1 except that the thickness satisfied the equation of tₐ=4.5 (mm) in place of the equation of tₐ=2.5 (mm) , that both ends of the tapered portion 72d, i.e., the intersection between the inner surface of the peripheral wall 72a and the inner surface of the tapered portion 72d and the intersection between the bottom surface of the flange 72c and the inner surface of the tapered portion 72d were rounded with a radius of 5 mm (R5), and that the inner surface of the tapered portion 72d had a surface roughness Ra of 2.5 µm. In other words, the outer tube 72 made of silicon carbide was fabricated so as to fulfill the conditions of 1) t_{a/}D₁=0.015, 2) tₐ×D₁=1,382 (mm²), 3) (D_{F2}-D_{F1})×t_{c}/(D₁×tₐ)=0.21, and 4) L₁/L₂=4.3. In this case, the equation of t_{c}×(D_{F2}-D_{F1})=296 (mm²) was established.

When the outer tube thus fabricated was used at a temperature beyond 700°C, the flange was significantly deformed in comparison with the outer tube in Example 1, and the generated thermal stresses were increased. However, it was possible to avoid stress concentration by rounding both edges and controlling the surface roughness. By using a dual tube 73 with the outer tube 72 combined with the inner tube 71 used in Example 1, a process for depositing a CVD film of silicon nitride at 780°C was repeated 40 times. The O-ring 68 was not seized, and the outer tube 72 was not fractured.

### EXAMPLE 3

An outer tube 72 made of silicon carbide was prepared so as to fulfill the conditions of the inner diameter: D₁=324 (mm), the thickness: tₐ=3.5 (mm), the height: 1,300 (mm), the thickness of the flange: t_{c}=12 (mm), the outer diameter of the flange: D_{F2}=410 (mm), the inner diameter of the flange: D_{F1}=328 (mm), the height of the tapered portion: L₁=2 (mm) and the expansion of the tapered portion: L₂=2 (mm), that is to say, 1) tₐ/D₁=0.011, 2) tₐ×D₁=1,134 (mm²), 3) (D_{F2}-D_{F1})×t_{c}/(D₁×tₐ)=0.87, and 4) L₁/L₂=1. In this case, the equation of t_{c}×(D_{F2}-D_{F1})=984 (mm²) was established. Additionally, an inner tube 71, which was made of the same material as the outer tube, was prepared so as to have an inner diameter of 260 (mm) and an outer diameter of 268 (mm). The outer tube and the inner tube were combined together as a dual tube 73.

A deposition process wherein the dual tube 73 was used to deposit a D-Poly CVD film on each of semiconductor wafers W in a low pressure CVD system with a heater having a height H of 80 mm was conducted at 550°C. The outer tube was cracked on the first test.

### EXAMPLE 4

An outer tube 72 made of silicon carbide is prepared so as to fulfill the conditions of the inner diameter: D₁=386 (mm) , the thickness: tₐ=2.5 (mm) , the height: 1,100 (mm), the thickness of the flange: t_{c}=20 (mm), the outer diameter of the flange: D_{F2}=470 (mm), the inner diameter of the flange: D_{F1}=390 (mm), the height of the tapered portion: L₁=2 (mm) and the expansion of the tapered portion: L₂=2 (mm), that is to say, 1) tₐ/D₁=0.0065, 2) tₐ×D₁=965 (mm²), 3) (D_{F2}-D_{F1})×t_{c}/(D₁×tₐ)=1.66, and 4) L₁/L₂=1. In this case, the equation of t_{c}×(D_{F2}-D_{F1})=1,600 (mm²) is established.

A deposition process wherein the outer tube 72 is used to deposit an oxide film on each of semiconductor wafers W in a high temperature thermal treatment reactor with a heater having a height H of 150 mm is conducted at 150°C. The outer tube is cracked from an outer peripheral portion of the flange 72c on the first test.

When the novel outer tube is used in a thermal treatment system for semiconductors, the distance between the lower edge of the heater and the base can be shortened since the novel outer tube is formed so as to satisfy the particular conditions. By this arrangement, the isothermal heating zone can be enlarged to the increase the throughput of wafers at one time in a thermal treatment system for semiconductors using the novel outer tube. In accordance with the present invention, the outer tube can cope with an increase in diameter without providing the base with a special projection for supporting the flange of the outer tube. Additionally, the outer tube has an advantage of being superior in durability. Accordingly, the novel outer tube is free from problems, such as gas leakage due to an insufficient sealing pressure in the case of contacting and supporting the projection, and insufficient cooling of the flange of the outer tube. Additionally, the novel outer tube has an advantage of avoiding contamination caused by particles since the outer tube is made of silicon carbide.

The entire disclosure of Japanese Patent Application No. 2003-051329 filed on February 27, 2003 including specification, claims, drawings and summary is incorporated herein by reference in its entirety.

## Claims

1. An outer tube, which is made of silicon carbide, and which has an upper portion closed and a lower portion opened, has the lower portion formed with a tapered portion so as to expand a diameter thereof toward a lower end thereof, and has a flange formed on an outer peripheral side of the lower portion; the following conditions being met:
1) a ratio of tₐ/D₁ is from 0.0067 to 0.025,
2) a product of tₐ×D₁ is from 600 to 4,000 (mm²)
3) (D_{F2}-D_{F1})×t_{c}/(D₁×tₐ) is from 0.1 to 0.7, and
4) L₁/L₂ is from 1 to 10;
where the outer tube has a thickness of tₐ (mm) and an inner diameter of D₁ (mm), the flange has a thickness of t_{c} (mm), an inner diameter of D_{F1} (mm) and an outer diameter of D_{F2} (mm), and the tapered portion has a height L₁ (mm) and an expanse of L₂ (mm).

2. The outer tube according to Claim 1, wherein the tapered portion has upper and lower edges of an inner peripheral side rounded with a radius of 2 mm (R2) or above.

3. The outer tube according to Claim 1 or 2, wherein the tapered portion has an inner surface having a surface roughness Ra of not greater than 7 µm.

4. A thermal treatment system using an outer tube, which is made of silicon carbide, and which has an upper portion closed and a lower portion opened, has the lower portion formed with a tapered portion so as to expand a diameter thereof toward a lower end thereof, and has a flange formed on an outer peripheral side of the lower portion; the following conditions being met:
1) a ratio of tₐ/D₁ is from 0.0067 to 0.025,
2) a product of tₐ×D₁ is from 600 to 4,000 (mm²),
3) (D_{F2} - D_{F1})× t_{c}/ (D₁×tₐ) is from 0.1 to 0.7, and
4) L₁/L₂ is from 1 to 10;
where the outer tube has a thickness of tₐ (mm) and an inner diameter of D₁ (mm), the flange has a thickness of t_{c} (mm) , an inner diameter of D_{F1} (mm) and an outer diameter of D_{F2} (mm), and the tapered portion has a height L₁ (mm) and an expanse of L₂ (mm).

5. The thermal treatment system according to Claim 4, wherein the tapered portion has upper and lower edges of an inner peripheral side rounded with a radius of 2 mm (R2) or above.

6. The thermal treatment system according to Claim 4 or 5, wherein the tapered portion has an inner peripheral side having a surface roughness Ra of not greater than 7 µm.

7. The thermal treatment system according to Claim 4, 5 or 6, wherein the height L₁ of the tapered portion satisfies the relationship of H/4<L₁<3•H/4, where a distance between a lowest end of a heater and a bottom surface of the outer tube is H (mm).
